(19) **Europäisches Patentamt / European Patent Office / Office européen des brevets**

(11) **EP 2 184 786 A1**

(12) **EUROPEAN PATENT APPLICATION**
published in accordance with Art. 153(4) EPC

(43) Date of publication:
**12.05.2010 Bulletin 2010/19**

(51) Int Cl.:
**H01L 31/04** *(2006.01)*

(21) Application number: **08792726.5**

(22) Date of filing: **26.08.2008**

(86) International application number:
**PCT/JP2008/065180**

(87) International publication number:
**WO 2009/028492 (05.03.2009 Gazette 2009/10)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **31.08.2007 JP 2007226277**

(71) Applicant: **Toyota Jidosha Kabushiki Kaisha Toyota-shi, Aichi-ken 471-8571 (JP)**

(72) Inventors:
• **TAKEDA, Yasuhiko**
  **Aichi-gun**
  **Aichi 480-1192 (JP)**
• **ITO, Tadashi**
  **Aichi-gun**
  **Aichi 480-1192 (JP)**
• **MOTOHIRO, Tomoyoshi**
  **Aichi-gun**
  **Aichi 480-1192 (JP)**
• **NAGASHIMA, Tomonori**
  **Toyota-shi**
  **Aichi 471-8571 (JP)**

(74) Representative: **CBDL Patentanwälte**
  **Königstraße 57**
  **47051 Duisburg (DE)**

(54) **PHOTOVOLTAIC FORCE DEVICE**

(57) The present invention provides a hot carrier type photovoltaic device capable of effectively improving conversion efficiency even when the residence time of carriers in a light absorbing layer is short. The photovoltaic device includes: a light absorbing layer 2 that absorbs light and generates electrons and holes; an electron moving layer 3 that is provided adjacent to one surface of the light absorbing layer 2; a hole moving layer 4 that is provided adjacent to the other surface of the light absorbing layer 2; a negative electrode 5 that is provided on the electron moving layer 3; and a positive electrode 6 that is provided on the hole moving layer 4. The electron moving layer 3 has a conduction band 3a that has an energy gap narrower than that of a conduction band 2c of the light absorbing layer 2 and selectively transmits the electrons with a predetermined energy level Ee. The hole moving layer 4 has a valence band 4a that has an energy gap narrower than that of a valence band 2d of the light absorbing layer 2 and selectively transmits the holes with a predetermined energy level $E_h$. The light absorbing layer 2 includes p-type impurities or n-type impurities.

Fig.6

**Description**

**Technical Field**

The present invention relates to a photovoltaic device.

**Background Art**

In recent years, photovoltaic devices, such as solar cells, have drawn attention as a clean energy source that does not generate carbon dioxide. A commercially available photovoltaic device has a so-called "first generation" structure using a silicon wafer, which has low energy conversion efficiency and a high cost per unit power, as compared to a conventional power generating system.

In contrast to the first generation photovoltaic device, there is a so-called "second generation" structure. That is, for example, there is a thin film silicon type photovoltaic device (which decreases the thickness of a silicon layer to reduce, for example, energy and costs required for materials used and manufacture), a CIGS type photovoltaic device (which uses a non-Si-based semiconductor material, such as copper, indium, gallium, and selenium), and a dye-sensitized photovoltaic device. The conversion efficiency of the second generation photovoltaic device is equal to or lower than that of the first generation photovoltaic device, but the manufacturing costs thereof are lower than those of the first generation photovoltaic device. Therefore, they are expected to significantly reduce the manufacturing costs per unit power.

In contrast to the second generation photovoltaic device, so-called "third generation" structures have been proposed in order to significantly improve conversion efficiency while preventing an increase in manufacturing costs. The most promising one of the third generation structures is a hot carrier type photovoltaic device. In the hot carrier type photovoltaic device, carriers (electrons and holes) generated by photoexcitation in a light absorbing layer made of a semiconductor are extracted from the light absorbing layer before the energy of the carriers can be dissipated by phonon scattering. In this way, high conversion efficiency is achieved. The principle of the hot carrier type photovoltaic device is disclosed in, for example, Non-patent Citations 1 to 4.

(Non-Patent Citation 1) Robert T. Ross et al., "Efficiency of Hot-carrier Solar Energy Converters", American Institute of Physics, Journal of Applied Physics, May 1982, Vol. 53, No. 5, pp. 3813-3818

(Non-Patent Citation 2) Peter Würfel, "Solar Energy Conversion with Hot Electrons from Impact Ionization", Elsevier, Solar Energy Materials and Solar Cells, 1997, Vol. 46, pp. 43-52

(Non-Patent Citation 3) G. J. Conibeer et al., "On Achievable Efficiencies of Manufactured Hot Carrier Solar Cell Absorbers", 21st European Photovoltaic Solar Energy Conference, 4-8 September 2006, pp. 234-237

(Non-Patent Citation 4) Peter Würfel, "Particle Conservation in the Hot-carrier Solar Cell", Wiley InterScience, Progress in Photovoltaics: Research and Applications, 18 February 2005, Vol. 13, pp. 277-285

**Disclosure of the Invention**

(Technical Problem) In the above-mentioned Non-Patent Citations, the theoretical conversion efficiency of the hot carrier type photovoltaic device is 80% or more. However, the inventors' examinations proved that the actual conversion efficiency was about 50%. The reason is as follows. In general, as the density of carriers in the light absorbing layer is increased, the conversion efficiency tends to be improved. 80% conversion efficiency is obtained on the assumption that the carrier density is sufficiently high. In order to increase the carrier density, it is necessary to increase the time (residence time) from the generation of carriers in the light absorbing layer by photoexcitation to the extraction of the carriers to the outside of the light absorbing layer.

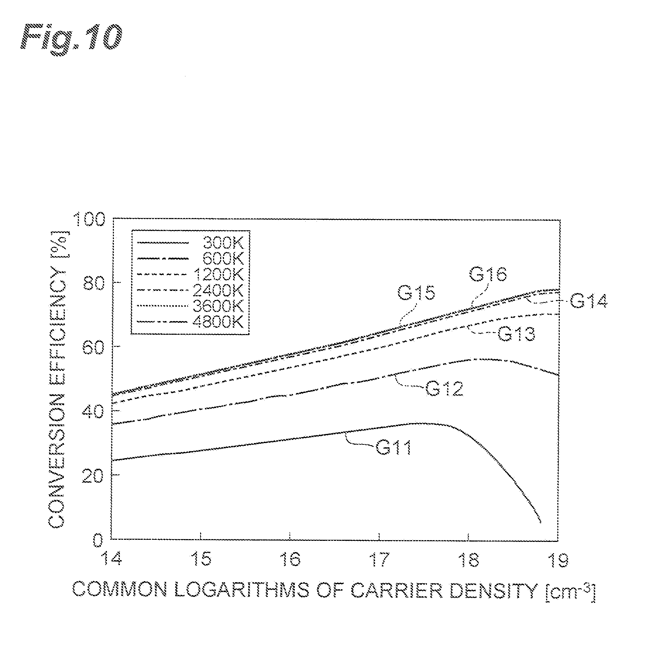

Fig. 10 is a graph illustrating the calculation result of the relationship between the density of carriers in the light absorbing layer and conversion efficiency when the energy loss of the carriers is neglected in the photovoltaic device according to the related art. In Fig. 10, graphs G11 to G16 indicate the relationship between the carrier density and the conversion efficiency when carrier temperatures are 300 [K], 600 [K], 1200 [K], 2400 [K], 3600 [K], and 4800 [K]. In Fig. 10, the effective mass of each of the electron and the hole is 0.4 and a concentration magnification is 1000. As can be seen from Fig. 10, at each carrier temperature, as the carrier density is increased, the conversion efficiency is improved.

However, in fact, as the residence time of the carriers in the light absorbing layer is increased, energy loss is more remarkable due to phonon scattering caused by carrier-lattice interaction. As a result, the conversion efficiency is not improved. Therefore, the actual conversion efficiency of the hot carrier type photovoltaic device is reduced to about 50%.

The invention has been made in order to solve the above-mentioned problems, and an object of the invention is to provide a hot carrier type photovoltaic device capable of effectively improving conversion efficiency even when the residence time of carriers in a light absorbing layer is short.

(Technical Solution) In order to achieve the object, according to an aspect of the invention, a photovoltaic device includes: a light absorbing layer that absorbs light and generates electrons and holes; an electron moving layer that is provided adjacent to one surface of the light absorbing layer; a hole moving layer that is provided adjacent to the other surface of the light absorbing layer; a negative electrode that is provided on the electron moving layer; and a positive electrode that is provided on the hole moving layer. The electron moving layer has a conduction band that is narrower than that of a conduction band of the light absorbing layer and selectively transmits the electrons with a predetermined first energy level. The hole moving layer has a valence band that is narrower than that of a valence band of the light absorbing layer and selectively transmits the holes with a predetermined second energy level. The light absorbing layer includes p-type impurities or n-type impurities.

The inventors focused attention on the following points related to the hot carrier type photovoltaic device. That is, in the hot carrier type photovoltaic device, the high-temperature electrons and holes generated in the light absorbing layer are extracted from the light absorbing layer while the energy (temperature) thereof is maintained. However, since the temperature of the electrodes to which the electrons and the holes are moved is substantially room temperature, entropy increases when the electrons and the holes are extracted from the light absorbing layer to the electrodes. That is, an energy loss corresponding to the increase in entropy occurs, and the conversion efficiency is reduced.

In the above-mentioned photovoltaic device, the light absorbing layer includes the p-type impurities (acceptors) or the n-type impurities (donors). For example, when the light absorbing layer includes the p-type impurities, the temperature of the holes originating from the previously doped p-type impurities is low (around room temperature). Therefore, even when the energy of the holes generated by photoexcitation is high, the average temperature of the holes is close to room temperature. Therefore, it is possible to decrease the temperature difference between the holes and the electrode when the holes are extracted from the light absorbing layer and prevent an increase in the entropy of the holes. Similarly, when the light absorbing layer includes the n-type impurities, the temperature of the electrons originating from the previously doped n-type impurities is low (around room temperature). Therefore, even when the energy of the electrons generated by photoexcitation is high, the average temperature of the electrons is close to room temperature. Therefore, it is possible to decrease the temperature difference between the electrons and the electrode when the electrons are extracted from the light absorbing layer and prevent an increase in the entropy of the electrons.

As such, according to the above-mentioned photovoltaic device, it is possible to prevent an increase in entropy when the electrons or the holes are extracted from the light absorbing layer to the electrode. Therefore, it is possible to effectively improve conversion efficiency even when the residence time of carriers in the light absorbing layer is short.

In the photovoltaic device according to the above-mentioned aspect, the light absorbing layer may include the p-type impurities, and the valence band of the hole moving layer may include top level of the valence band of the light absorbing layer. When the light absorbing layer includes the p-type impurities, the energy distribution of the holes in the entire light absorbing layer leans to the top of the valence band by the holes originating from the previously doped p-type impurities. When the valence band of the hole moving layer includes the top of the valence band of the light absorbing layer, it is possible to more effectively extract the holes arranged so as to lean to the top of the valence band of the light absorbing layer to the positive electrode through the valence band of the hole moving layer. Therefore, it is possible to further improve the conversion efficiency of the photovoltaic device. In addition, in this case, the top of the valence band of the hole moving layer may be higher than the top of the valence band of the light absorbing layer and lower than the quasi-Fermi level of the hole in the light absorbing layer.

In the photovoltaic device according to the above-mentioned aspect, the light absorbing layer may include the n-type impurities, and the conduction band of the electron moving layer may include the bottom of the conduction band of the light absorbing layer. When the light absorbing layer includes the n-type impurities, similar to the above, the energy distribution of the electrons in the entire light absorbing layer leans to the bottom of the conduction band by the electrons originating from the previously doped n-type impurities. When the conduction band of the electron moving layer includes the bottom of the conduction band of the light absorbing layer, it is possible to effectively extract the electrons arranged so as to lean to the bottom of the conduction band of the light absorbing layer to the negative electrode through the conduction band of the electron moving layer. Therefore, it is possible to further improve the conversion efficiency of the photovoltaic device. In addition, in this case, the bottom of the conduction band of the electron moving layer may be lower than the bottom of the conduction band of the light absorbing layer and higher than the quasi-Fermi level of the electron in the light absorbing layer.

In the photovoltaic device according to the above-mentioned aspect, the light absorbing layer may include the p-type impurities, and the energy level of the valence band of the hole moving layer may be substantially equal to the top of the valence band of the light absorbing layer. As described above, when the light absorbing layer includes the p-type impurities, the energy distribution of the holes in the entire light absorbing layer leans to the top of the valence band. Therefore, the energy level of the valence band of the hole moving layer of the holes that can selectively pass through the valence band of the hole moving layer is substantially equal to the top of the valence band of the light absorbing layer. As a result, the holes can pass through the hole moving layer with high efficiency and it is possible to improve the conversion efficiency of the photovoltaic device.

In the photovoltaic device according to the above-mentioned aspect, the light absorbing layer may include the n-type impurities, and the energy level of the conduction band of the electron moving layer may be substantially equal to the bottom of the conduction band of the light absorbing layer. Similar to the above, when the light absorbing layer includes the n-type impurities, the energy distribution of the electrons in the entire light absorbing layer leans to the bottom of the conduction band. Therefore, the first energy level of the electrons that can selectively pass through the conduction band of the electron moving layer is substantially equal to the bottom of the conduction band of the light absorbing layer. As a result, the electrons can pass through the electron moving layer with high efficiency and it is possible to improve the conversion efficiency of the photovoltaic device.

In the photovoltaic device according to the above-mentioned aspect, the concentration of the p-type impurities or the n-type impurities in the light absorbing layer may be equal to or more than $A \times 10^{13}$ [cm$^{-3}$] when incident light intensity is A [kW/m$^2$]. In this way, the density of the holes (electrons) originating from the p-type impurities or the n-type impurities previously doped in the light absorbing layer can be sufficiently higher than the density of the holes (electrons) generated by photoexcitation. Therefore, it is possible to make the temperature of the hole (electron) of the entire light absorbing layer close to room temperature. In addition, for example, a numerical value obtained by multiplying the intensity of reference sunlight (1 [kW/m$^2$] which is also represented by 1 [Sun]) by a concentration magnification may be appropriately used as the incident light intensity A [kW/m$^2$]. For example, in a non-concentration-type photovoltaic device, the incident light intensity A is 1 [kW/m$^2$]. In a concentration-type photovoltaic device with a concentration magnification of 1000, the incident light intensity A is 1000 [kW/m$^2$].

According to the photovoltaic device of the invention, it is possible to effectively improve conversion efficiency even when the residence time of carriers in a light absorbing layer is short.

**Brief Description of the Drawings**

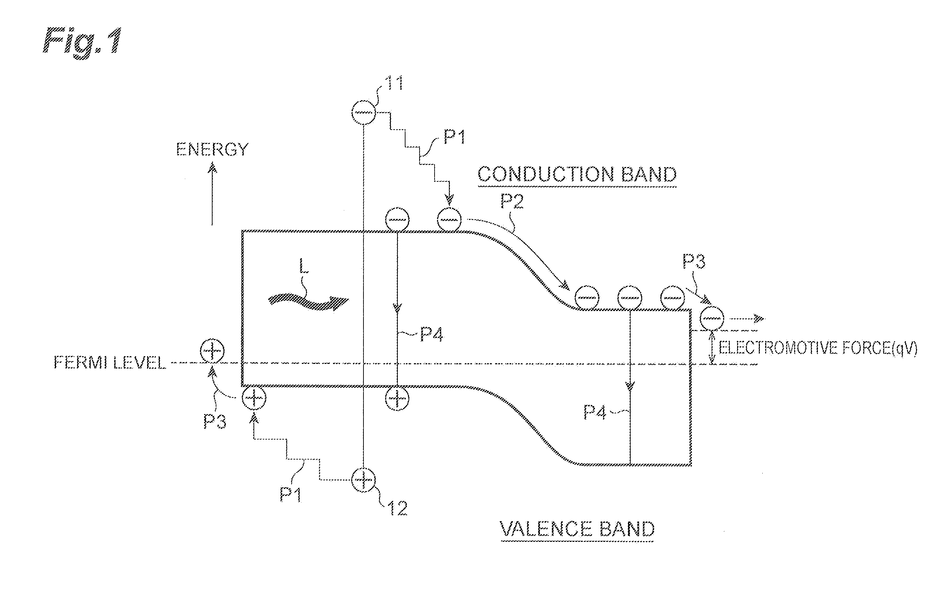

Fig. 1 is a diagram schematically illustrating the energy band of a photovoltaic device according to the related art using a pn junction of a semiconductor.

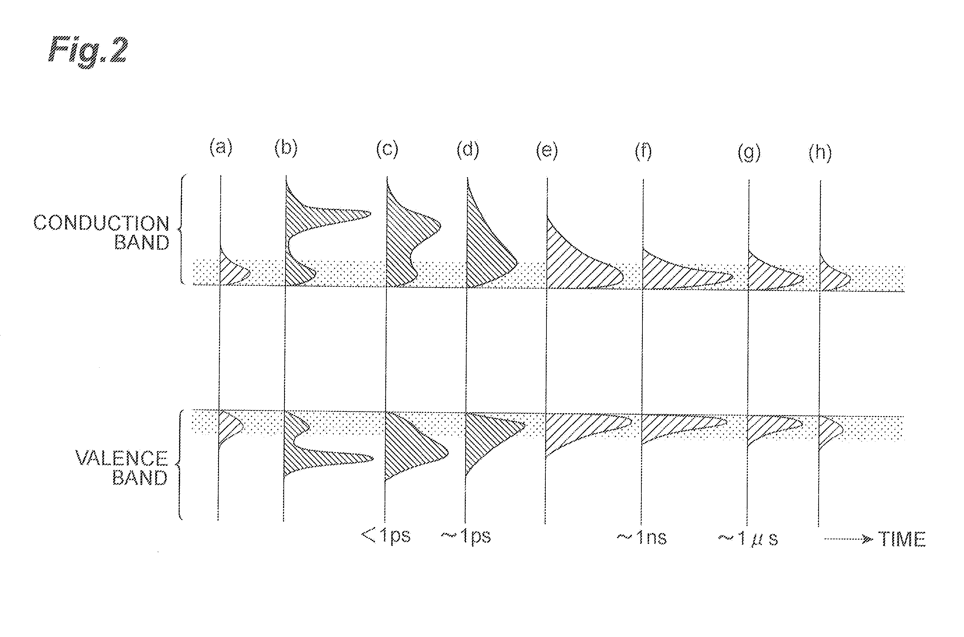

(a) to (h) of Fig. 2 are diagrams schematically illustrating variation in the energy distribution of electrons and holes when light is absorbed by a semiconductor.

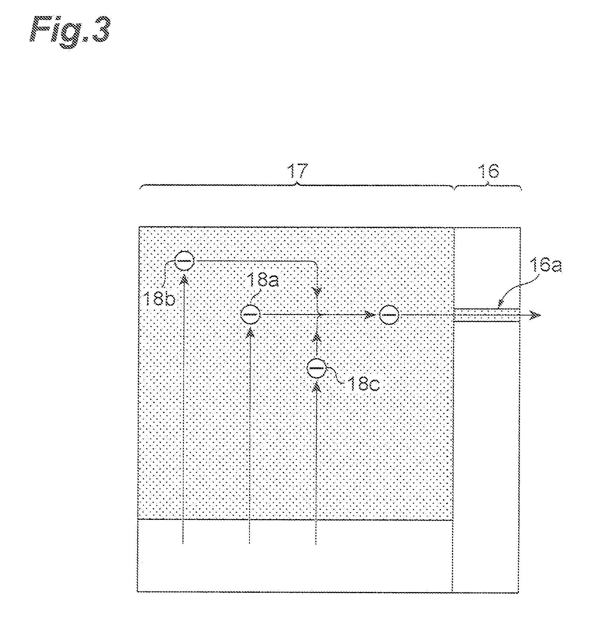

Fig. 3 is a diagram schematically illustrating the operation of a hot carrier type photovoltaic device.

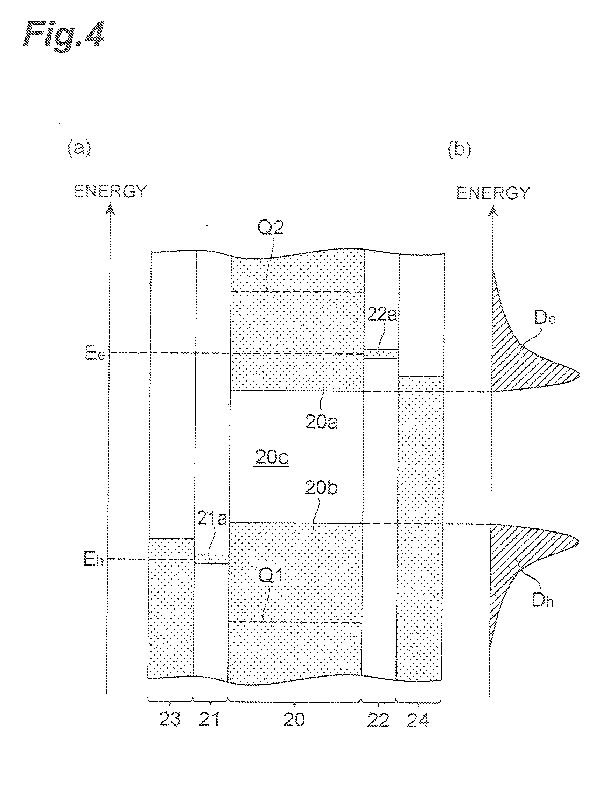

(a) of Fig. 4 is a diagram illustrating the energy band structure of a hot carrier type photovoltaic device according to the related art. (b) of Fig. 4 shows the energy distribution of carriers in a light absorbing layer when light is incident on the photovoltaic device shown in (a) of Fig. 4.

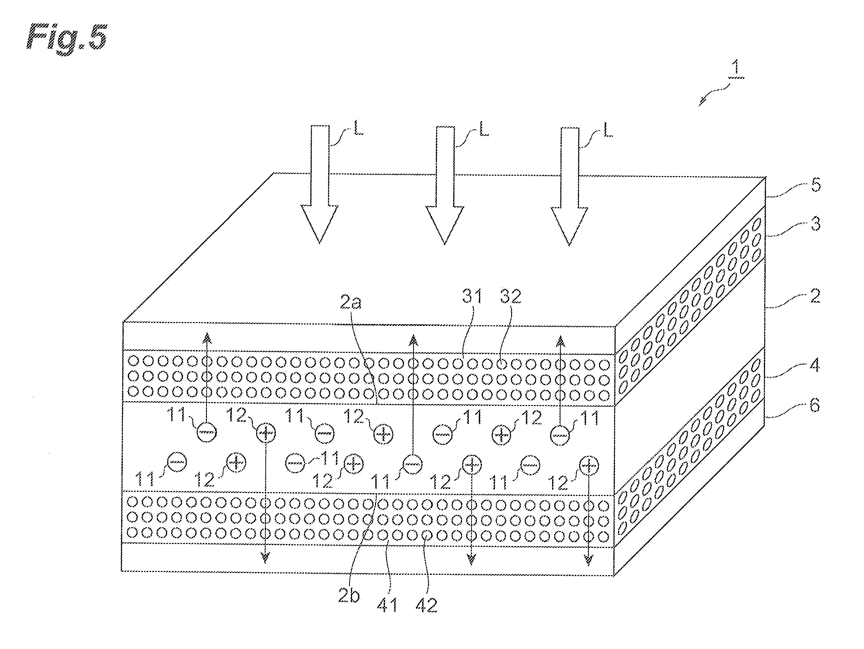

Fig. 5 is a perspective view illustrating the structure of a photovoltaic device according to an embodiment of the invention.

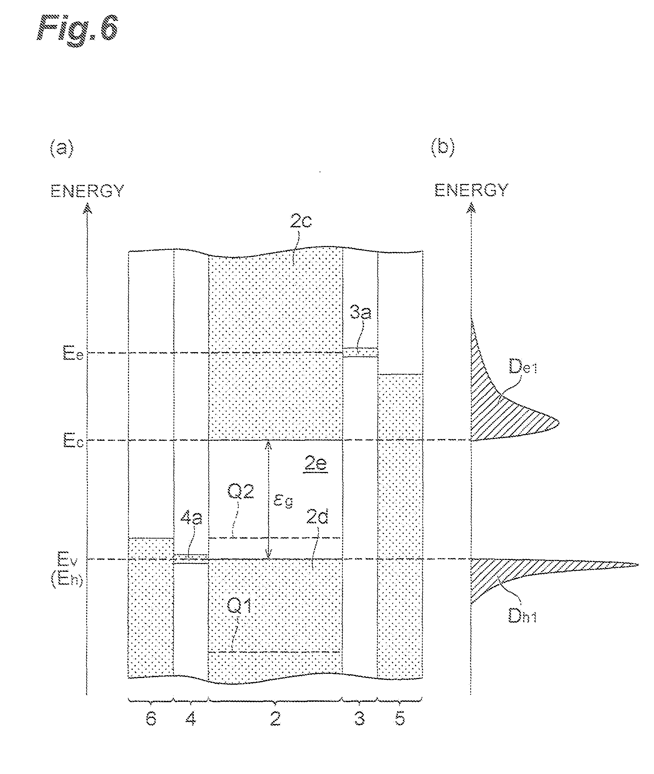

(a) of Fig. 6 is a diagram illustrating an energy band structure when a light absorbing layer is doped with p-type impurities. (b) of Fig. 6 shows the energy distribution of carriers in the light absorbing layer when light is incident on the photovoltaic device shown in (a) of Fig. 6.

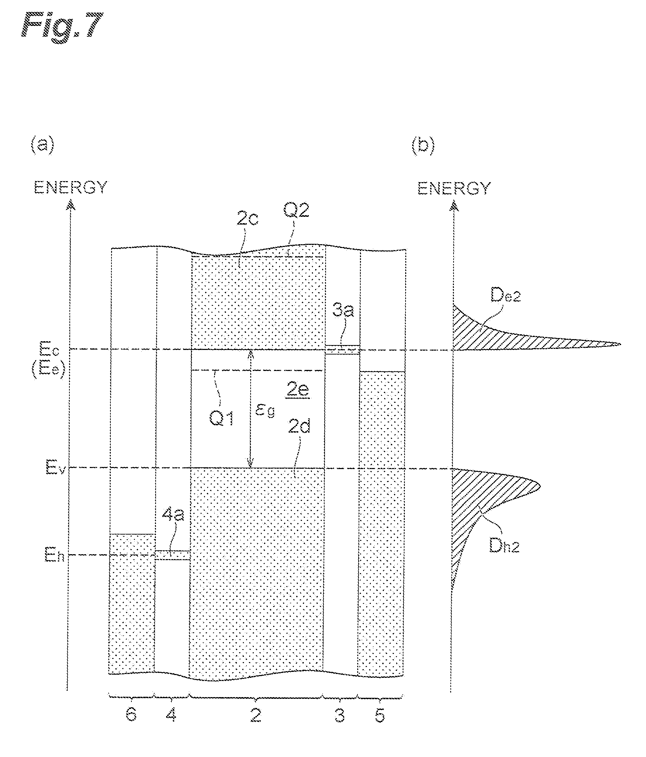

(a) of Fig. 7 is a diagram illustrating an energy band structure when a light absorbing layer is doped with n-type impurities. (b) of Fig. 7 shows the energy distribution of carriers in the light absorbing layer when light is incident on the photovoltaic device shown in (a) of Fig. 7.

Fig. 8 is a graph illustrating the relationship between the density of photoexcited carriers in the light absorbing layer and conversion efficiency when the light absorbing layer is doped with the p-type impurities.

Fig. 9 is a table illustrating examples and comparative examples of the photovoltaic device according to the embodiment.

Fig. 10 is a graph illustrating the relationship between the density of carriers in the light absorbing layer and conversion efficiency in the photovoltaic device according to the related art.

(Explanation of Reference) 1: PHOTOVOLTAIC DEVICE, 2, 17, 20: LIGHT ABSORBING LAYER, 2c, 20a: CONDUCTION BAND OF LIGHT ABSORBING LAYER, 2d, 20b: VALENCE BAND OF LIGHT ABSORBING LAYER, 3, 16, 22: ELECTRON MOVING LAYER, 4, 21: HOLE MOVING LAYER, 3a, 16a, 22a: CONDUCTION BAND OF ELECTRON MOVING LAYER, 4a, 21a: VALENCE BAND OF HOLE MOVING LAYER, 5, 24: NEGATIVE ELECTRODE, 6, 23: POSITIVE ELECTRODE, 31, 41: BARRIER AREA, 32, 42: SEMICONDUCTOR QUANTUM STRUCTURE, Q1: QUASI-FERMI LEVEL OF ELECTRONS, Q2: QUASI-FERMI LEVEL OF HOLES

**Best Mode for Carrying Out the Invention**

Hereinafter, a photovoltaic device according to an embodiment of the invention will be described in detail with reference to the accompanying drawings. In the description of the drawings, the same components are denoted by the same reference numerals and a description thereof will not be repeated.

<Embodiments> A photovoltaic device according to an embodiment of the invention will be described. Before the description of the photovoltaic device, first, a power generation mechanism of a hot carrier type photovoltaic device will be described in detail.

Fig. 1 is a diagram schematically illustrating the energy band of a photovoltaic device according to the related art using a pn junction of a semiconductor. In the photovoltaic device, when light L with energy that is higher than the band gap of a semiconductor is absorbed, first, an electron 11 is excited to an energy level that is higher than the bottom of the conduction band. In this case, a hole 12 is disposed at an energy level that is lower than the top of a valence band. Then, the electron 11 and the hole 12 interact with a crystal lattice of the semiconductor to generate a phonon and move to the bottom of the conduction band and the top of the valence band, respectively. Therefore, the energy of each of the hole and the electron is reduced (an arrow P1 in Fig. 1). In this process, it is difficult to extract the energy consumed to generate the phonon as power to the outside, which results in a reduction in the power generation efficiency of the photovoltaic device. In the photovoltaic device, the power generation efficiency is reduced by a voltage drop (an arrow P2 in Fig. 1) in the pn junction, a voltage drop (an arrow P3 in Fig. 3) in a portion bonded to a lead electrode, and the recombination (an arrow P4 in Fig. 4) between the electron 11 and the hole 12, in addition to the above-mentioned process. Among them, the energy reducing process represented by the arrow P1 has the greatest effect on the power generation efficiency.

(a) to (h) of Fig. 2 are diagrams schematically illustrating a variation in the energy distribution of the electron and the hole when light is absorbed by the semiconductor. In Fig. 2, (a) shows the energy distribution of the electron and the hole before light is absorbed. When light with energy that is higher than the band gap is absorbed, each of electron-hole pairs is generated as shown in (b). In this step, the energy distribution of the electrons and that of the holes is different from a Fermi distribution and is not in a thermal equilibrium state. Therefore, it is meaningless to define the temperatures of the electrons and the holes. As shown in (c) and (d), the electrons interact with other electrons and the holes interact with other holes within 1 picosecond. As a result, the electrons and the holes reach the thermal equilibrium states in the conduction band and the valence band, respectively. In the process shown in (b) to (d), since energy is exchanged between the electrons and between the holes, there is no energy loss in the entire system. Then, as shown in (e) and (f), the electrons reach the bottom of the conduction band and the holes reach the top of the valence band while the electrons and the holes interact with the crystal lattice to generate optical phonons within several picoseconds. The optical phonons are changed to acoustic phonons within several tens of picoseconds. In the process shown in (e) and (f), an energy loss from the electrons and holes to the scattering of the optical phonon and then the acoustic phonon occurs. Finally, as shown in (g) and (h), the electron is recombined with the hole by a radiation or non-radiation process. The hot carrier type photovoltaic device extracts the electrons and the holes to the outside of a light absorbing layer in a "hot" state before the electrons and the holes generate the optical phonons resulting in energy reduction.

As shown in Fig. 3, in the hot carrier type photovoltaic device, an electron moving layer (energy selective contact layer) 16 having a conduction band 16a with a very narrow energy band is provided adjacent to a light absorbing layer 17 such that only an electron 18a at a specific energy level can reaches an electrode through the electron moving layer 16. An electron 18b at an energy level that is higher than that of the electron 18a and an electron 18c at an energy level that is lower than that of the electron 18a exchange their energies to reach sufficiently high energy levels to pass through the electron moving layer 16. Then, the electrons reach the electrode through the electron moving layer 16 and contribute to output. As a result, it is possible to prevent an electron at a high energy level from generating an optical phonon (energy reducing process) and thus reduce energy loss. The description of Fig. 3 relates to the movement of the electron, but it may be similarly applied to the movement of the hole. In this case, it is also possible to reduce energy loss.

As a technique for reducing the energy loss by the process (energy reducing process) shown in (e) and (f) of Fig. 2 to improve the power generation efficiency of the photovoltaic device, a tandem-type photovoltaic device has been put into practical use. In the tandem-type photovoltaic device, plural kinds of pn junction layers with different band gaps are optically connected in series to each other. When a pn junction layer made of a material with a wide band gap is arranged on a light incident side, light with high energy is absorbed by the pn junction layer, but light with low energy passes through the pn junction layer and is then absorbed by the next pn junction layer made of a material with a narrow band gap. Therefore, it is possible to reduce the difference between the energy and the band gap of the absorbing materials of the absorbed light, as compared to a photovoltaic device including one pn junction. As a result, it is possible to reduce an energy loss due to a reduction in the energy of the electron and the hole. However, in the tandem-type photovoltaic device, there are limitations in combinations of the pn junction layer with different band gaps. Therefore, it is difficult to significantly reduce an energy loss.

In the hot carrier type photovoltaic device, if all of the excited electrons and holes can be extracted to the outside of the light absorbing layer before the optical phonon is generated, it is possible to achieve conversion efficiency higher than that of the tandem-type photovoltaic device. In addition, the structure of the hot carrier type photovoltaic device is simpler than the tandem-type photovoltaic device including a combination of a plurality of pn junctions. As a result, it is possible to reduce manufacturing costs.

Fig. 4(a) is a diagram illustrating the energy band structure of a general hot carrier type photovoltaic device. The photovoltaic device shown in Fig. 4(a) includes a light absorbing layer 20 that is made of a semiconductor with a relatively narrow band gap, a hole moving layer 21 and an electron moving layer 22 that are provided adjacent to both sides of the light absorbing layer 20 and serve as energy selective contact layers, and metal electrodes (a positive electrode 23 and a negative electrode 24) that collect electrons and holes.

The light absorbing layer 20 has a conduction band 20a, a valence band 20b, and a forbidden band 20c. The electron moving layer 22 is arranged adjacent to one surface of the light absorbing layer 20 and has a conduction band 22a. The conduction band 22a has an energy band that is significantly narrower than that of the conduction band 20a of the light absorbing layer 20 such that only an electron with a specific energy level (energy $E_e$) can reach the negative electrode 24 through the conduction band 22a. The hole moving layer 21 is arranged adjacent to the other surface of the light absorbing layer 20 and has a valence band 21a. The valence band 21a has an energy band that is significantly narrower than that of the valence band 20b of the light absorbing layer 20 such that only a hole with a specific energy level (energy $E_h$) can reach the positive electrode 23 through the valence band 21a. The energy level $E_e$ of the conduction band 22a of the electron moving layer 22 is set to be higher than the bottom of the conduction band 20a of the light absorbing layer 20. Similarly, the energy level $E_h$ of the valence band 21 a of the hole moving layer 21 is set to be lower than the top of the valence band 20b of the light absorbing layer 20. In Fig. 4(a), dashed lines Q1 and Q2 indicate the quasi-Fermi levels of the electron and the hole in the light absorbing layer 2, respectively.

When light is incident on the photovoltaic device, the energy distribution of carriers shown in Fig. 4(b) is formed in the light absorbing layer 20. In Fig. 4(b), a distribution De indicates the energy distribution of electrons in the conduction band 20a, and a distribution Dh indicates the energy distribution of holes in the valence band 20b. As such, when light is incident on the light absorbing layer 20, the energy levels of the electron and the hole are symmetrically distributed in the light absorbing layer 20. Before the electron and the hole generate an optical phonon (that is, energy reduction occurs), they pass through the conduction band 22a and the valence band 21a and are extracted to the negative electrode 24 and the positive electrode 23, respectively.

The photovoltaic device according to the embodiment of the invention will be described below with reference to the power generation mechanism of the above-mentioned general hot carrier type photovoltaic device. Fig. 5 is a perspective view illustrating the structure of a photovoltaic device 1 according to this embodiment. Referring to Fig. 5, the photovoltaic device 1 includes a light absorbing layer 2, an electron moving layer 3, a hole moving layer 4, a negative electrode 5, and a positive electrode 6.

The light absorbing layer 2 absorbs light L, such as sunlight, and generates carriers (the electron 11 and the hole 12) with energy corresponding to the wavelength of the light. The light absorbing layer 2 is made of, for example, Si, Ge, or a semiconductor material, such as a group III-V compound, and is substantially doped with n-type impurities or p-type impurities. The concentration of the impurities in the light absorbing layer 2 is preferably equal to or more than $A \times 10^{13}$ [cm$^{-3}$] when the intensity of incident light is A [kW/m$^2$]. For example, the light absorbing layer 2 is made of a material having a band gap of 0.5 to 1.0 [eV] as a main component.

The electron moving layer 3 is provided adjacent to one surface 2a of the light absorbing layer 2. The electron moving layer 3 has a conduction band narrower than that of the conduction band of the light absorbing layer 2. In this way, the electron moving layer 3 selectively transmits electrons with a predetermined energy level. As the structure of the electron moving layer 3, for example, a barrier area 31 may include a semiconductor quantum structure 32, such as a quantum well layer, a quantum wire, or a quantum dot, that exhibits a carrier confinement effect (quantum effect). In this case, in the electron moving layer 3, the conduction band in which there are electrons is narrowed by the carrier confinement effect of the semiconductor quantum structure 32. In one embodiment, the barrier area 31 is made of a semiconductor material with a band gap of 4.0 to 5.0 [eV], and the thickness of the barrier area 31 is in the range of 2 to 10 [nm]. When the semiconductor quantum structure 32 is composed of a quantum dot, the quantum dot is made of a semiconductor material with a band gap of 1.8 to 2.2 eV, and the diameter ($\phi$) of the dot is in the range of 2 to 5 nm.

The negative electrode 5 is provided on the electron moving layer 3. The electron generated in the light absorbing layer 2 reaches the negative electrode 5 through the electron moving layer 3 and is collected in the negative electrode 5. The negative electrode 5 is composed of, for example, a transparent conductive film so as to transmit light incident on the light absorbing layer 2. The negative electrode 5 may be coated with an antireflection film, which is a combination of a high refractive index film and a low refractive index film. In addition, the negative electrode 5 may be a comb-shaped electrode made of a metal material, instead of the transparent electrode film.

The hole moving layer 4 is provided adjacent to the other surface 2b of the light absorbing layer 2. The hole moving layer 4 has a valence band narrower than that of the valence band of the light absorbing layer 2. In this way, the hole moving layer 4 selectively transmits holes with a predetermined energy level. As the structure of the hole moving layer 4, the same structure as that of the electron moving layer 3 may be used. For example, a barrier area 41 may include a semiconductor quantum structure 42, such as a quantum well layer, a quantum wire, or a quantum dot, that exhibits the carrier confinement effect (quantum effect). In this case, the energy band gap of the valence band in which there are holes is narrowed by the carrier confinement effect of the semiconductor quantum structure 42. In one embodiment, the barrier area 41 is made of a semiconductor material with a band gap of 4.0 to 5.0 [eV], and the thickness of the barrier area 41 is in the range of 2 to 10 [nm]. When the semiconductor quantum structure 42 is composed of a quantum dot, the quantum dot is made of a semiconductor material with a band gap of 1.2 to 1.8 eV, and the diameter ($\phi$) of the dot is in the range of 4 to 7 nm.

The positive electrode 6 is provided on the hole moving layer 4. The hole generated in the light absorbing layer 2 reaches the positive electrode 6 through the hole moving layer 4 and is collected in the positive electrode 6. The positive electrode 6 is made of a metal material such as aluminum. In this embodiment, the negative electrode 5 is provided on a light incident surface (one surface 2a) of the light absorbing layer 2, and the positive electrode 6 is provided on a rear surface (the other surface 2b). However, the positive electrode may be provided on the light incident surface, and the negative electrode may be provided on the rear surface. In this case, the hole moving layer is provided adjacent to the light incident surface of the light absorbing layer, and the electron moving layer is provided adjacent to the rear surface of the light absorbing layer. In addition, the positive electrode is composed of, for example, a transparent conductive film so as to transmit light and the negative electrode is composed of a metal film.

Fig. 6(a) and Fig. 7(a) are diagrams illustrating the energy band structure of the photovoltaic device 1 according to this embodiment. Fig. 6(a) shows a case in which the light absorbing layer 2 is doped with p-type impurities, and Fig. 7(a) shows a case in which the light absorbing layer 2 is doped with n-type impurities. As shown in Fig. 6(a) and Fig. 7 (a), the light absorbing layer 2 of the photovoltaic device 1 has a conduction band 2c, a valence band 2d, and a forbidden band 2e, and the band gap energy $\varepsilon_g$ of the forbidden band 2e is relatively low. When the light absorbing layer 2 is doped with p-type impurities, as shown in Fig. 6(a), the bottom level $E_c$ of the conduction band 2c and the top level $E_v$ of the valence band 2d with respect to the energy levels $E_e$ and $E_h$ are lower than those when the light absorbing layer 2 is not doped with impurities (Fig. 4(a)). In the drawings, the dashed lines Q1 and Q2 indicate the quasi-Fermi levels of the electrons and the holes in the light absorbing layer 2, respectively.

The electron moving layer 3 provided adjacent to one surface of the light absorbing layer 2 has a conduction band 3a for selectively transmitting electrons with a predetermined energy level $E_e$. The conduction band 3a is significantly narrower than that of the conduction band 2c of the light absorbing layer 2 such that only the electron with a specific energy level $E_e$ can reach the negative electrode 5 through the conduction band 3 a.

The hole moving layer 4 provided adjacent to the other surface of the light absorbing layer 2 has a valence band 4a for selectively transmitting holes with a predetermined energy level $E_h$. The valence band 4a is significantly narrower than that of the valence band 2d of the light absorbing layer 2 such that only the hole with a specific energy level $E_h$ can reach the positive electrode 6 through the valence band 4a.

When the light absorbing layer 2 is doped with p-type impurities, as shown in Fig. 6(a), the valence band 4a of the hole moving layer 4 is set so as to include the top level $E_v$ of the valence band 2d of the light absorbing layer 2. Preferably, the top of the valence band 4a of the hole moving layer 4 is set to be higher than the top level $E_v$ of the valence band 2d of the light absorbing layer 2 and lower than the quasi-Fermi level Q2 of the holes in the light absorbing layer 2. The bottom of the valence band 4a of the hole moving layer 4 is set to be lower than the top level $E_v$ of the valence band 2d of the light absorbing layer 2. The predetermined energy level $E_h$ of the valence band 4a of the hole moving layer 4 is set to be substantially equal to the top level $E_v$ of the valence band 2d of the light absorbing layer 2. The predetermined energy level $E_e$ of the conduction band 3a of the electron moving layer 3 is set such that $E_e$-$E_h$ is substantially equal to the average energy of light absorbed by the light absorbing layer 2 or it is 0.1 [eV] lower than the average energy.

In the energy band structure shown in Fig. 6(a), when light is incident on the light absorbing layer 2, the energy distribution of carriers shown in Fig. 6(b) is formed in the light absorbing layer 2. In Fig. 6(b), a distribution $De_1$ indicates the energy distribution of electrons in the conduction band 2c, and a distribution $Dh_1$ indicates the energy distribution of holes in the valence band 2d. The electron generated in the light absorbing layer 2 by the absorption of light is excited to an energy level corresponding to the wavelength of the incident light. That is, when light with a short wavelength is incident, electrons at a high energy level are generated in the conduction band 2c, and when light with a long wavelength is incident, electrons at a low energy level are generated in the conduction band 2c. At the same time, when light with a short wavelength is incident, holes at a low energy level are generated in the valence band 2d, and when light with a long wavelength is incident, holes at a high energy level are generated in the valence band 2d. In the conduction band 2c, the electron at a high energy level and the electron at a low energy level interact with each other to change their energy. As a result, the energy distribution $De_1$ of the electrons is in a thermal equilibrium state. Similarly, in the valence band 2d, the energy distribution $Dh_1$ of the holes is in the thermal equilibrium state.

As shown in Fig. 6(b), the energy distribution $De_1$ of the electrons in the light absorbing layer 2 is formed in the wide energy range of the conduction band 2c. In contrast, when the density of the holes originating from the p-type impurities is sufficiently more than that of the holes generated by photoexcitation, the energy distribution $Dh_1$ of the holes leans to the top (energy level $E_v$) of the valence band 2d. The reason is that, even when the hole generated by photoexcitation has a high energy level, the temperature of the hole in the thermal equilibrium state is substantially maintained at room temperature since the temperature of the hole originating from the p-type impurities is close to room temperature. Before the electrons and holes generated in this way generate optical phonons (that is, energy reduction occurs), they pass through the conduction band 3a of the electron moving layer 3 and the valence band 4a of the hole moving layer 4 and are extracted to the negative electrode 5 and the positive electrode 6, respectively.

When the light absorbing layer 2 is doped with n-type impurities, as shown in Fig. 7(a), the conduction band 3a of the electron moving layer 3 is set so as to include the bottom level $E_c$ of the conduction band 2c of the light absorbing layer 2. Preferably, the bottom level of the conduction band 3a of the electron moving layer 3 is set to be lower than the bottom level $E_c$ of the conduction band 2c of the light absorbing layer 2 and higher than the quasi-Fermi level Q1 of the electrons in the light absorbing layer 2. The top level of the conduction band 3a of the electron moving layer 3 is set to be higher than the bottom level $E_c$ of the conduction band 2c of the light absorbing layer 2. The predetermined energy level $E_e$ of the conduction band 3a of the electron moving layer 3 is set to be substantially equal to the bottom level $E_c$ of the conduction band 2c of the light absorbing layer 2. The predetermined energy level $E_h$ of the valence band 4a of the hole moving layer 4 is set such that $E_e$-$E_h$ is substantially equal to the average energy of light absorbed by the light absorbing layer 2 or it is 0.1 [eV] lower than the average energy.

In the energy band structure shown in Fig. 7(a), when light is incident on the light absorbing layer 2, the energy distribution of carriers shown in Fig. 7(b) is formed in the light absorbing layer 2. In Fig. 7(b), a distribution $De_2$ indicates the energy distribution of electrons in the conduction band 2c, and a distribution $Dh_2$ indicates the energy distribution of holes in the valence band 2d.

As shown in Fig. 7(b), the energy distribution $Dh_2$ of the holes in the light absorbing layer 2 is formed in a wide energy range of the valence band 2d. In contrast, when the density of the electrons originating from the n-type impurities is sufficiently more than that of the electrons generated by photoexcitation, the energy distribution $De_2$ of the electrons leans to the bottom (energy level $E_c$) of the conduction band 2c. The reason is that, even when the temperature of the electrons generated by photoexcitation is high, the temperature of the electrons in the thermal equilibrium state is substantially maintained at room temperature since the temperature of the electrons originating from the n-type impurities is close to room temperature. Before the electrons and holes generated in this way generate optical phonons (that is, energy reduction occurs), they pass through the conduction band 3 a of the electron moving layer 3 and the valence band 4a of the hole moving layer 4 and are extracted to the negative electrode 5 and the positive electrode 6, respectively.

Next, the effects of the photovoltaic device 1 according to this embodiment will be described. First, the problems of the general hot carrier type photovoltaic device having the energy band structure shown in Fig. 4(a) are examined, and then the photovoltaic device 1 according to the this embodiment capable of solving the problems will be described.

The level of the power output from the hot carrier type photovoltaic device shown in Fig. 4(a) is theoretically considered. The following are assumed in order to derive the output power.

(A) The band gap of each of the hole moving layer 21 and the electron moving layer 22 is infinitesimal and the conductance thereof is infinite, focusing attention on only the characteristics of the light absorbing layer 20.
(B) The carrier excited to a high energy level is extracted to the outside of the light absorbing layer 20 before energy reduction occurs. That is, the carrier-lattice interaction is neglected.
(C) Impact ionization and non-radiative recombination do not occur.
(D) All light components with energy that is higher than the band gap of the light absorbing layer 20 are absorbed by the light absorbing layer 2. That is, the thickness of the light absorbing layer 20 is sufficiently greater than the reciprocal of a light absorption coefficient of the light absorbing layer.
(E) The carriers generated by photoexcitation immediately become into a thermal equilibrium state (however, not to a thermal equilibrium state with respect to the lattice) by elastic scattering between the carriers, and it is possible to represent the energy distribution with a Fermi distribution function. That is, the collision time of the carriers is regarded to be infinitesimal.
(F) The inside of the light absorbing layer 20 is maintained in an electrically neutral state.
(G) The density, temperature, and quasi-Fermi level of the carriers in the light absorbing layer 20 are constant in the thickness direction. That is, the diffusion coefficient of the carrier is regarded to be infinite.

An output power P is calculated by the following Expression 1 on the above-mentioned assumption:

[Equation 1]

$$P = J(V_e - V_h).$$

In Equation 1, J indicates a current density, Ve and Vh indicate the energies of the extracted electron and hole, respectively, and (Ve-Vh) indicates an output voltage.

The current density J has the following relationship with a sunlight spectrum $I_S(\varepsilon)$ and a radiation spectrum $I_R$ ($\varepsilon$, $\mu_e$, $\mu_h$, $T_e$, $T_h$) from the light absorbing layer 20 caused by recombination:

[Equation 2]

$$J = \int_{\varepsilon_g}^{\infty} d\varepsilon [I_S(\varepsilon) - I_R(\varepsilon, \mu_e, \mu_h, T_e, T_h)],$$

[Equation 3]

$$I_S(\varepsilon) = \frac{2\Omega_S}{h^3 c^2} \cdot \frac{\varepsilon^2}{\exp\left(\dfrac{\varepsilon}{k_B T_S}\right) - 1},$$

and

[Equation 4]

$$I_R(\varepsilon, \mu_e, \mu_h, T_e, T_h) = \frac{2\Omega_R}{h^3 c^2} \cdot \frac{\varepsilon^2}{\exp\left(\dfrac{\varepsilon_e - \mu_e}{k_B T_e} - \dfrac{\varepsilon_h - \mu_h}{k_B T_h}\right) - 1}.$$

In Equations 2 to 4, $\varepsilon_g$ indicates the band gap energy of the light absorbing layer 20, $\mu_e$ and $\mu_h$ indicate the quasi-Fermi levels of the electrons and the holes, respectively, and $T_e$ and $T_h$ indicate the temperature of the electrons and the temperature of the holes, respectively. In addition, h indicates the Planck's constant, c indicates the velocity of light, $k_B$ indicates the Boltzmann constant, and $T_S$ indicates the surface temperature (5760[K]) of the sun. In addition, $\Omega_S$ indicates the incident azimuth of sunlight, $\Omega_R$ indicates the azimuth of radiation by radiative recombination (where $\Omega_S = 6.8\times10^{-5}$ [rad] (1 [Sun] radiation) and $\Omega_R = \pi$[rad]).

The electron energy $V_e$ and the hole energy $V_h$ satisfy the following relationship:

[Equation 5]

$$\begin{aligned} V_e - V_h &= [E_e - T_{RT}\Delta S_e] - [E_h - T_{RT}\Delta S_h] \\ &= [E_e - (E_e - \mu_e)T_{RT}/T_e] - [E_h - (E_h - \mu_h)T_{RT}/T_h], \end{aligned}$$

and

[Equation 6]

$$J(E_e - E_h) = \int_{\varepsilon_g}^{\infty} d\varepsilon \cdot \varepsilon [I_S(\varepsilon) - I_R(\varepsilon, \mu_e, \mu_h, T_e, T_h)]$$

In Equations 5 and 6, $E_e$ indicates the energy level of the electron that is selectively transmitted by the electron moving layer 22, and $E_h$ indicates the energy level of the hole that is selectively transmitted by the hole moving layer 21. In addition, $\Delta S_e$ and $\Delta S_h$ indicate the increments of entropy when the electrons at the temperature $T_e$ and the holes at the temperature $T_h$ are extracted to the negative electrode 24 and the positive electrode 23 at a temperature $T_{RT}$ (room temperature) in the light absorbing layer 20.

In the above-mentioned Non-Patent Citations 1 to 4, the conditions for obtaining the high conversion efficiency of the hot carrier type photovoltaic device are theoretically examined, and 80% or more of conversion efficiency is obtained. The high conversion efficiency is obtained on the assumption of the above-mentioned three items (A) to (C). However, the inventors focused their attention on (B) among these assumed items. That is, the time from the generation of carriers by photoexcitation to the extraction of the carriers to the outside of the light absorbing layer 2, that is, a residence time ($\tau_r$) needs to be sufficiently shorter than an energy reduction time ($\tau_t$) in order to establish the assumption (B). In a general semiconductor, the energy reduction time $\tau_t$ is several picoseconds. Even in the semiconductor superlattice structure or a specific material, such as InN, the energy reduction time $\tau_t$ is several hundreds of picoseconds. Therefore, since the residence time $\tau_r$ of the carriers in the light absorbing layer 20 is limited to be shorter than the time, the carriers are not sufficiently accumulated in the light absorbing layer 20, and the carrier density ($n_c$) of the light absorbing layer 20 is restricted.

In general, as the carrier density $n_c$ of the light absorbing layer 20 is increased, the conversion efficiency is improved. In order to increase the carrier density $n_c$, for example, a method is used which focuses light and makes the focused light incident on the light absorbing layer 20. However, the maximum value of a practically available concentration magnification is about 500, and a concentration magnification that can be achieved by experiments is about 1000. Here, the conversion efficiency of the photovoltaic device when the concentration magnification is 1000 is considered.

When the carrier density $n_c$, the electron temperature $T_e$, and the hole temperature $T_h$ are determined, the quasi-Fermi level $\mu_e$ of the electrons and the quasi-Fermi level $\mu_h$ of the holes are determined, and conversion efficiency is determined on the basis of the quasi-Fermi levels $\mu_e$ and $\mu_h$. Fig. 10 shows the relationship between the calculated conversion efficiency and the carrier density $n_c$. In Fig. 10, each of the effective masses $m_e$ and $m_h$ of the electron and the hole is 0.4 and the electron temperature $T_e$ and the hole temperature $T_h$ are the same temperature ($T_H$). In addition, the band gap energy $\varepsilon_g$ of the light absorbing layer 20 is optimized with respect to the carrier density $n_c$ and the temperature $T_H$. As can be seen from Fig. 10, in order to obtain about 80% conversion efficiency, the carrier density $n_c$ needs to be equal to or more than $1 \times 10^{19}$ [cm$^{-3}$]. As described above, the energy reduction time $\tau_t$ of the carrier is a maximum of several hundreds of picoseconds. However, since a material capable of increasing the energy reduction time $\tau_t$ has been examined for the future, it is assumed in this embodiment that the energy reduction time $\tau_t$ of the carrier is 1 nanosecond and the residence time $\tau_r$ of the carrier in the light absorbing layer 20 is 100 picoseconds. Even when the residence time $\tau_r$ is assumed to be long, the carrier density $n_c$ is about $1 \times 10^{15}$ [cm$^{-3}$] and the conversion efficiency is in the range of 50 to 60%. Under the virtual conditions, such as the assumption (B), about 80% conversion efficiency is obtained. However, actually, the conversion efficiency is only in the range of 50 to 60%. The above-mentioned calculation is obtained when the concentration magnification is 1000. When the concentration magnification is reduced, the conversion efficiency is further reduced. In fact, for example, energy loss due to a reduction in the energy of the carrier or energy loss when the carrier is moved to each electrode through the electron moving layer (hole moving layer) is added. Therefore, the conversion efficiency is further reduced from the above-mentioned value.

High-efficiency photovoltaic devices have been developed in addition to the hot carrier type photovoltaic device. For example, a triple-junction photovoltaic device has been developed which is made of a group III-V compound semiconductor and has 39% conversion efficiency. In addition, four-junction to six-junction photovoltaic devices have been developed in order to further improve the conversion efficiency. Therefore, when the conversion efficiency of the hot carrier type photovoltaic device is equal to or less than 60%, the superiority thereof may be damaged. For this reason, the inventors have examined a structure capable of improving the conversion efficiency even when the residence time $\tau_r$ of the light absorbing layer 20 is short.

In the above-mentioned logical examination, as shown in Fig. 4(b), it is assumed that the energy distributions $De_1$ and $Dh_1$ of the electrons and the holes are symmetric with respect to the center of the forbidden band 20c. That is, the only case considered is one in which $T_e = T_h$ and $E_e = -E_h$ are established and the light absorbing layer 20 is made of an intrinsic semiconductor (undoped).

Numerical calculation by the inventors proved that the item $I_R$ caused by radiative recombination could be almost neglected when the electron temperature $T_e$ and the hole temperature $T_h$ were higher than 1500 [K] and the band gap energy $\varepsilon_g$ was higher than 0.5 [eV] in Equations 2 and 6. In this case, when the band gap energy $\varepsilon_g$ is determined, the current density J is substantially determined by Equation 2. Therefore, in order to improve the conversion efficiency, the difference ($V_e$-$V_h$) between the electron energy $V_e$ and the hole energy $V_h$ may be increased. The difference ($V_e$-$V_h$) depends on the difference ($E_e$-$E_h$) between the energy levels $E_e$ and $E_h$ of the electron and the hole passing through the electron moving layer and the hole moving layer and Equation 5, whereas the difference ($E_e$-$E_h$) is determined by Equation 6. Here, a scheme for increasing the difference ($V_e$-$V_h$) with respect to the difference ($E_e$-$E_h$) is needed.

When the electron temperature $T_e$ is increased in order to obtain high conversion efficiency, the quasi-Fermi level $\mu_e$ of the electrons is lowered. In this case, since the value of ($E_e$-$\mu_e$) is increased, the electron energy $V_e$ is lowered due to an increase in entropy during the extraction of the electrons (see Equation 5). When the energy level $E_e$ of the electron passing through the electron moving layer is lowered and the electron temperature $T_e$ is decreased, the quasi-Fermi level $\mu_e$ of the electron is heightened and an entropy increment $\Delta S_e$ is reduced. In particular, when the energy level $E_e$ of the electron passing through the electron moving layer is set to around the bottom of the conduction band and the electron temperature $T_e$ is set close to room temperature (for example, 300[K]), it is possible to effectively reduce the entropy increment $\Delta S_e$. In addition, the electron energy $V_e$ is likely to be lowered by lowering the energy level $E_e$. However, since the value of ($B_e$-$B_h$) is determined, the energy level $E_h$ is also lowered by a value corresponding to a lowering in the energy level $E_e$. Therefore, it is considered that the output voltage ($V_e$-$V_h$) is increased.

In the above-mentioned description, a structure for reducing the entropy increment $\Delta S_e$ of the electron has been examined, but the invention may also be applied to a structure for reducing the entropy increment $\Delta S_h$ of the hole. That is, when the energy level $E_h$ of the hole passing through the hole moving layer is heightened and the hole temperature $T_h$ is decreased, the quasi-Fermi level $\mu_h$ of the hole is lowered and the entropy increment $\Delta S_h$ is reduced. In particular, when the energy level $E_h$ of the hole passing through the hole moving layer is set to around the bottom of the conduction band and the hole temperature $T_h$ is set close to room temperature (for example, 300[K]), it is possible to effectively reduce the entropy increment $\Delta S_h$.

In order to make the hole temperature $T_h$ close to room temperature (300 [K]), similar to the light absorbing layer 2 according to this embodiment, a light absorbing layer may be doped with p-type impurities (acceptors). Since the temperature of the hole originating from the previously doped p-type impurities is low (around room temperature), the hole temperature $T_h$ in the thermal equilibrium state is close to room temperature even when the energy of the hole generated by photoexcitation is high. In this way, it is possible to reduce the temperature difference between the hole and the positive electrode 6 when the hole is extracted from the light absorbing layer 2 and prevent an increase in the entropy of the hole.

In order to make the electron temperature $T_e$ close to room temperature (300 [K]), it is possible to apply the same method as that used for the hole temperature $T_h$. That is, the light absorbing layer 2 is doped with n-type impurities (donors). Since the temperature of the electron originating from the previously doped n-type impurities is low (around room temperature), the electron temperature $T_e$ in the thermal equilibrium state is close to room temperature even when the energy of the electron generated by photoexcitation is high. In this way, it is possible to reduce the temperature difference between the electron and the negative electrode 5 when the electron is extracted from the light absorbing layer 2 and prevent an increase in the entropy of the electron.

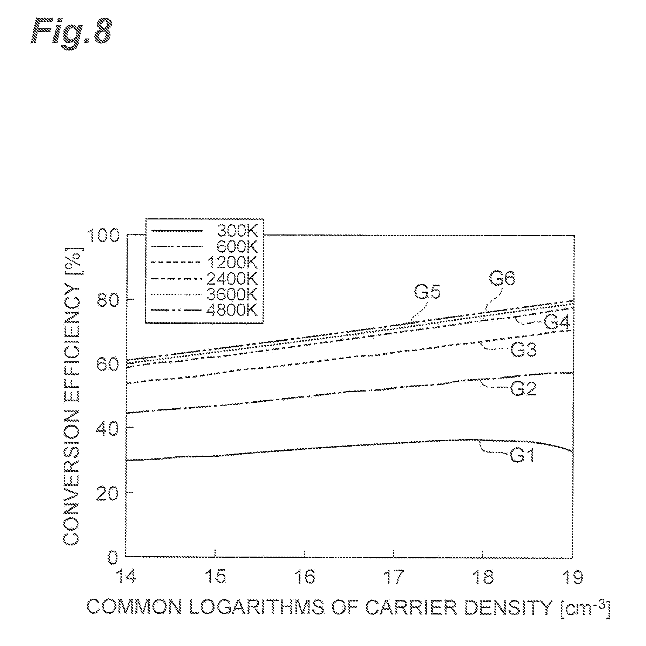

Fig. 8 is a graph illustrating the relationship between the density of photoexcited carriers in the light absorbing layer 2 and conversion efficiency when the light absorbing layer 2 is doped with p-type impurities. In Fig. 8, graphs G1 to G6 indicate the relationship between the density of photoexcited carriers in the light absorbing layer 2 and conversion efficiency when the temperatures of the photoexcited carriers are 300 [K], 600 [K], 1200 [K], 2400 [K], 3600 [K], and 4800 [K]. In Fig. 8, the concentration of the p-type impurities is $1 \times 10^{17}$ [cm$^{-3}$], the effective mass of each of the electron and the hole is 0.4, and the concentration magnification is 1000. However, since the calculation results are obtained on the assumption that the concentration of the p-type impurities is sufficiently more than the density of the photoexcited carriers, the density of the photoexcited carriers that is equal to or more than $1 \times 10^{16}$ [cm$^{-3}$] is physically meaningless. The comparison between Fig. 8 and Fig. 10 shows that, when the carrier density ($1 \times 10^{15}$ [cm$^{-3}$] or less) at a practical and at a certain carrier (electron) temperature, it is possible to significantly improve the conversion efficiency by doping the light absorbing layer 2 with p-type impurities.

A supplementary description of the above-mentioned examination results will be made below. The following relationship is established among the electron density $n_e$ of the light absorbing layer 2, the quasi-Fermi level $\mu_e$ of the electrons, and the electron temperature $T_e$:

[Equation 7]

$$ n_e = \frac{8\sqrt{2}\pi m_e^{3/2}}{h^3} \int_{\varepsilon_g}^{\infty} d\varepsilon \sqrt{\varepsilon - \varepsilon_g / 2} \frac{1}{\exp[(\varepsilon - \mu_e)/k_B T_e + 1]}. $$

In Equation 7, the center of the band gap $\varepsilon_g$ is the origin of an energy axis. The hole density $n_h$ is represented similarly to Equation 7 using the quasi-Fermi level $\mu_h$ of the hole and the hole temperature $T_h$.

Of the electron density $n_e$ and the hole density $n_h$, the density $n_c$ of carriers, which are components generated by absorption of light, has the following relationship with the density Ns of photons absorbed in the light absorbing layer 2, an average residence time $\tau_r$, and the thickness d of the light absorbing layer 2:

[Equation 8]

$$n_c = \frac{N_S \tau_r}{d},$$

and

[Equation 9]

$$N_S = \int_{\varepsilon_g}^{\infty} d\varepsilon I_S(\varepsilon).$$

The density Ns of the absorbed photons is determined by the intensity of incident light and the band gap energy $\varepsilon_g$. For example, when the intensity of incident light is 1 [kW/m²] and the band gap energy $\varepsilon_g$ is 0, the density Ns of the absorbed photons is $6.3 \times 10^{17}$ [cm⁻²/s], which is substantially equal to the density ($6.46 \times 10^{17}$ [cm⁻²/s]) of incident photons with the AMO spectrum. When the density Ns of the absorbed photons and the thickness d of the light absorbing layer 2 are applied to Equations 7 and 8, the relationship among the carrier density $n_c$, the average residence time $\tau_r$, the quasi-Fermi level $\mu_e$ of the electrons, the quasi-Fermi level $\mu_h$ of the holes, and the electron temperature $T_e$ are established. When the average residence time $\tau_r$ is determined by the relationship, the carrier density $n_c$ is determined, and the relationship between the quasi-Fermi level $\mu_e$ of the electrons and the electron temperature $T_e$ and the relationship between the quasi-Fermi level $\mu_h$ of the holes and the hole temperature $T_h$ are derived.

When Equation 5 is rearranged, the following Equation 10 is obtained:

[Equation 10]

$$V_e - V_h = \mu_e(T_{RT}/T_e) - \mu_h(T_{RT}/T_h) + \Delta E(1 - T_{RT}/T_h) - E_e(T_{RT}/T_e - T_{RT}/T_h)$$

(where $\Delta E = Ee - Eh$).

Therefore, in order to increase the difference ($V_e$-$V_h$), if $T_e > T_h$, that is, if the light absorbing layer 2 is doped with p-type impurities, it is preferable to maximize the energy level $E_e$ of the conduction band 3 a of the electron moving layer 3, and it is more preferable to set the energy level $E_h$ of the valence band 4a of the hole moving layer 4 to the top of the valence band 2d of the light absorbing layer 2. If $T_e < T_h$, that is, if the light absorbing layer 2 is doped with n-type impurities, it is preferable to minimize the energy level $E_e$ of the conduction band 3a of the electron moving layer 3, and it is more preferable to set the energy level $E_e$ to the bottom of the conduction band 2c of the light absorbing layer 2.

As described above, according to the photovoltaic device 1 of this embodiment, it is possible to prevent an increase in entropy when the electron or the hole is moved from the light absorbing layer 2 to the negative electrode 5 or the positive electrode 6. Therefore, even though the residence time $\tau_r$ of the carriers in the light absorbing layer 2 is short, it is possible to effectively improve conversion efficiency.

In the photovoltaic device 1 according to this embodiment, preferably, the concentration of the p-type impurities or the n-type impurities in the light absorbing layer 2 is equal to or more than A $\times 10^{13}$ [cm⁻³] when incident light intensity is A [kW/m²]. In this case, before light is absorbed, the hole temperature $T_h$ (or the electron temperature $T_e$) is approximately 300 [K], and the quasi-Fermi level $\mu_h$ ($\mu_e$) of the holes (electrons) is disposed immediately above the top of the valence band 2d (immediately below the bottom of the conduction band 2c). New holes (electrons) are generated by light absorption and the density of the holes is significantly lower than the density of the holes (electrons) generated by doping. Therefore, the hole temperature $T_h$ (electron temperature $T_e$) and the quasi-Fermi level $\mu_h$ ($\mu_e$) are hardly changed. Thus, it is possible to effectively make the hole temperature $T_h$ (electron temperature $T_e$) of the entire light absorbing layer 2 close to room temperature. In addition, for example, a numerical value obtained by multiplying the intensity of reference sunlight (1 [kW/m²] which is also represented by 1 [Sun]) by the concentration magnification may be appropriately used as the incident light intensity A [kW/m$^2$]. For example, in a non-concentration-type photovoltaic device, the incident light intensity A is 1 [kW/m$^2$]. In a concentration-type photovoltaic device with a concentration magnification of 1000, the incident light intensity A is 1000 [kW/m$^2$].

As described above, when the light absorbing layer 2 includes p-type impurities (see Fig. 6(a)), it is preferable that the valence band 4a of the hole moving layer 4 include the top level $E_v$ of the valence band 2d of the light absorbing layer 2. When the light absorbing layer 2 includes p-type impurities, the energy distribution of the holes in the entire light absorbing layer 2 leans to the top of the valence band 2d by the holes originating from the previously doped p-type impurities, as shown in Fig. 6(b). When the valence band 4a of the hole moving layer 4 includes the bottom level $E_v$ of the valence band 2d of the light absorbing layer 2, it is possible to more effectively extract the holes arranged so as to lean to the top of the valence band 2d of the light absorbing layer 2 to the positive electrode 6 through the valence band 4a of the hole moving layer 4. Therefore, it is possible to further improve the conversion efficiency of the photovoltaic device 1. In addition, in this case, the top level of the valence band 4a of the hole moving layer 4 may be higher than the top level $E_v$ of the valence band 2d of the light absorbing layer 2 and lower than the quasi-Fermi level $\mu_h$ of the holes in the light absorbing layer 2.

When the light absorbing layer includes n-type impurities (see Fig. 7(a)), it is preferable that the conduction band 3a of the electron moving layer 3 include the bottom level $E_c$ of the conduction band 2c of the light absorbing layer 2. When the light absorbing layer 2 includes n-type impurities, similar to the above, the energy distribution of the electrons in the entire light absorbing layer 2 leans to the bottom of the conduction band 2c due to the electrons originating from the previously doped n-type impurities, as shown in Fig. 7(b). When the conduction band 3a of the electron moving layer 3 includes the bottom level $E_c$ of the conduction band 2c of the light absorbing layer 2, it is possible to effectively extract the electrons arranged so as to lean to the bottom of the conduction band 2c of the light absorbing layer 2 to the negative electrode 5 through the conduction band 3a of the electron moving layer 3. Therefore, it is possible to further improve the conversion efficiency of the photovoltaic device 1. In addition, in this case, the bottom level of the conduction band 3a of the electron moving layer 3 may be lower than the bottom level $E_c$ of the conduction band 2c of the light absorbing layer 2 and higher than the quasi-Fermi level $\mu_e$ of the electron in the light absorbing layer 2.

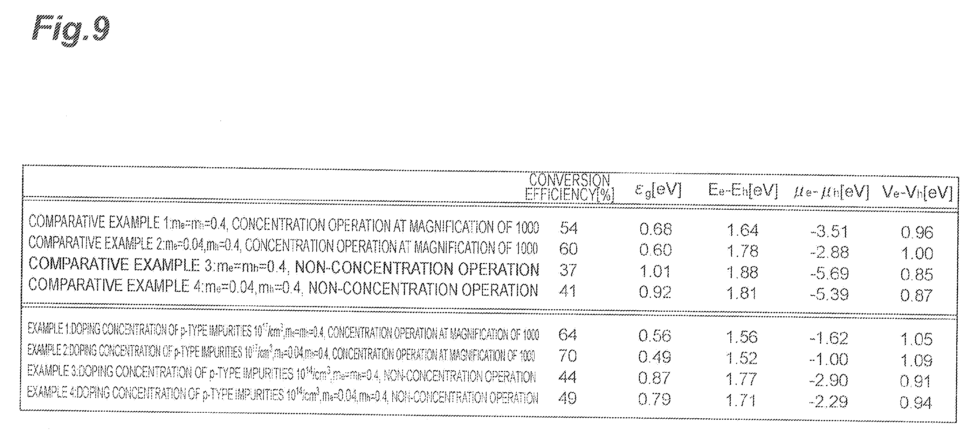

<Examples> Fig. 9 is a table illustrating examples and comparative examples of the photovoltaic device 1 according to the above-described embodiment. In Examples 1 to 4 shown in the table, the following were examined: when the light absorbing layer 2 was doped with p-type impurities and the concentration of the doped p-type impurities and the effective masses $m_e$ and $m_h$ of the electron and the hole, and the concentration magnification were set to various values, the optimal band gap energy $\varepsilon_g$, the difference ($E_e$-$E_h$) between the energy level $E_e$ of the conduction band 3a of the electron moving layer 3 and the energy level $E_h$ of the valence band 4a of the hole moving layer 4, the difference ($\mu_e$-$\mu_h$) between the quasi-Fermi level $\mu_e$ of the electrons and the quasi-Fermi level $\mu_h$ of the holes, the difference ($V_e$-$V_h$) between the electron energy $V_e$ and the hole energy $V_h$, and conversion efficiency.

In Comparative examples 1 to 4 compared to Examples 1 to 4, the following were examined: when the light absorbing layer was not doped with p-type impurities or n-type impurities and the effective masses $m_e$ and $m_h$ of the electron and the hole and the concentration magnification were set to various values, the optimal band gap energy $\varepsilon_g$, the differences ($E_e$-$E_h$), ($\mu_e$-$\mu_h$), and ($V_e$-$V_h$), and conversion efficiency.

Referring to Fig. 9, for example, if $m_e$ = $m_h$ = 0.4 and the concentration magnification is 1000, the conversion efficiency of Comparative example 1 in which the light absorbing layer is not doped with impurities is 54%. In contrast, the conversion efficiency of Example 1 in which the light absorbing layer is doped with p-type impurities is 64%, and is 10% higher than that when no impurities are doped. In Examples 2 to 4, the conversion efficiency is 7% to 10% higher than that in Comparative examples 2 to 4.

As a material capable of achieving the band gap energy $\varepsilon_g$ and the effective masses $m_e$ and $m_h$ according to Examples 1 to 4 shown in Fig. 9, any of the following materials are used: a group-IV binary compound such as $Si_XGe_{1-X}$; a group III-V ternary compound such as $In_XGa_{1-X}As$, $In_XGa_{1-X}Sb$, $Al_XGa_{1-X}Sb$, $GaAs_XSb_{1-X}$, or $InAs_XP_{1-X}$; a group III-V quaternary compound obtained by combining four of these elements (In, Ga, As, Sb, and Al). In addition, group I-III-VI compounds, such as $CuIn_XGa_{1-X}Se$ and $AgIn_XGa_{1-X}Se$, may be used.

The photovoltaic device according to the invention is not limited to the above-described embodiment, but it may be changed in various ways. For example, in the above-described embodiment, the structure of the electron moving layer (hole moving layer) that selectively transmits the electrons (holes) with a predetermined energy level includes semiconductor quantum structures, such as a quantum well layer, a quantum wire, and a quantum dot in the barrier area. However, various structures may be used as the structure of the electron moving layer (hole moving layer) as long as they can form a conduction band (valence band) with a narrow energy gap.

**Industrial Applicability**

According to the photovoltaic device of the invention, it is possible to effectively improve conversion efficiency even when the residence time of carriers in the light absorbing layer is short.

**Claims**

1. A photovoltaic device comprising:

   a light absorbing layer that absorbs light and generates electrons and holes;
   an electron moving layer that is provided adjacent to one surface of the light absorbing layer;
   a hole moving layer that is provided adjacent to the other surface of the light absorbing layer;
   a negative electrode that is provided on the electron moving layer; and
   a positive electrode that is provided on the hole moving layer,
   wherein the electron moving layer has a conduction band that is narrower than that of a conduction band of the light absorbing layer and selectively transmits the electrons with a predetermined first energy level,
   the hole moving layer has a valence band that is narrower than that of a valence band of the light absorbing layer and selectively transmits the holes with a predetermined second energy level, and
   the light absorbing layer includes p-type impurities or n-type impurities.

2. The photovoltaic device according to claim 1,
   wherein the light absorbing layer includes the p-type impurities, and
   the valence band of the hole moving layer includes the bottom level of the valence band of the light absorbing layer.

3. The photovoltaic device according to claim 2,
   wherein the top level of the valence band of the hole moving layer is higher than the top level of the valence band of the light absorbing layer and lower than the quasi-Fermi level of the holes in the light absorbing layer.

4. The photovoltaic device according to claim 1,
   wherein the light absorbing layer includes the n-type impurities, and
   the conduction band of the electron moving layer includes the bottom level of the conduction band of the light absorbing layer.

5. The photovoltaic device according to claim 4,
   wherein the bottom level of the conduction band of the electron moving layer is lower than the bottom level of the conduction band of the light absorbing layer and higher than the quasi-Fermi levels of the electron in the light absorbing layer.

6. The photovoltaic device according to claim 1,
   wherein the light absorbing layer includes the p-type impurities, and
   the energy level of the valence band of the hole moving layer is substantially equal to the top level of the valence band of the light absorbing layer.

7. The photovoltaic device according to claim 1,
   wherein the light absorbing layer includes the n-type impurities, and
   the energy level of the conduction band of the electron moving layer is substantially equal to the bottom level of the conduction band of the light absorbing layer.

8. The photovoltaic device according to any one of claims 1 to 7,
   wherein the concentration of the p-type impurities or the n-type impurities in the light absorbing layer is equal to or more than $A \times 10^{13}$ [cm$^{-3}$] when incident light intensity is A [kW/m$^2$].

*Fig.1*

Fig.2

*Fig.3*

*Fig.4*

(a)

(b)

EP 2 184 786 A1

*Fig.5*

*Fig.6*

*Fig.7*

(a)

(b)

Fig.8

Fig.9

| | CONVERSION EFFICIENCY[%] | $\varepsilon_g[eV]$ | $E_e\text{-}E_h[eV]$ | $\mu_e\text{-}\mu_h[eV]$ | $V_e\text{-}V_h[eV]$ |
|---|---|---|---|---|---|
| COMPARATIVE EXAMPLE 1:$m_e$=$m_h$=0.4, CONCENTRATION OPERATION AT MAGNIFICATION OF 1000 | 54 | 0.68 | 1.64 | -3.51 | 0.96 |
| COMPARATIVE EXAMPLE 2:$m_e$=0.04,$m_h$=0.4, CONCENTRATION OPERATION AT MAGNIFICATION OF 1000 | 60 | 0.60 | 1.78 | -2.88 | 1.00 |
| COMPARATIVE EXAMPLE 3:$m_e$=$m_h$=0.4, NON-CONCENTRATION OPERATION | 37 | 1.01 | 1.88 | -5.69 | 0.85 |
| COMPARATIVE EXAMPLE 4:$m_e$=0.04,$m_h$=0.4, NON-CONCENTRATION OPERATION | 41 | 0.92 | 1.81 | -5.39 | 0.87 |
| EXAMPLE 1:DOPING CONCENTRATION OF p-TYPE IMPURITIES $10^{17}$/cm$^3$,$m_e$=$m_h$=0.4, CONCENTRATION OPERATION AT MAGNIFICATION OF 1000 | 64 | 0.56 | 1.56 | -1.62 | 1.05 |
| EXAMPLE 2:DOPING CONCENTRATION OF p-TYPE IMPURITIES $10^{17}$/cm$^3$,$m_e$=0.04,$m_h$=0.4, CONCENTRATION OPERATION AT MAGNIFICATION OF 1000 | 70 | 0.49 | 1.52 | -1.00 | 1.09 |
| EXAMPLE 3:DOPING CONCENTRATION OF p-TYPE IMPURITIES $10^{14}$/cm$^3$,$m_e$=$m_h$=0.4, NON-CONCENTRATION OPERATION | 44 | 0.87 | 1.77 | -2.90 | 0.91 |
| EXAMPLE 4:DOPING CONCENTRATION OF p-TYPE IMPURITIES $10^{14}$/cm$^3$,$m_e$=0.04,$m_h$=0.4, NON-CONCENTRATION OPERATION | 49 | 0.79 | 1.71 | -2.29 | 0.94 |

Fig.10

## INTERNATIONAL SEARCH REPORT

International application No.

PCT/JP2008/065180

A. CLASSIFICATION OF SUBJECT MATTER
*H01L31/04(2006.01)i*

According to International Patent Classification (IPC) or to both national classification and IPC

B. FIELDS SEARCHED

Minimum documentation searched (classification system followed by classification symbols)
H01L31/04

Documentation searched other than minimum documentation to the extent that such documents are included in the fields searched
Jitsuyo Shinan Koho       1922-1996   Jitsuyo Shinan Toroku Koho   1996-2008
Kokai Jitsuyo Shinan Koho   1971-2008   Toroku Jitsuyo Shinan Koho   1994-2008

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | Peter Wurfel, Solar energy conversion with hot electrons from impact ionisation, Solar Energy Materials and Solar Cells, 1997.04.01, Vol.46, No.1, pp.43-52 | 1<br>2-8 |
| Y<br>A | Matthias Neges et al., Monte Carlo simulation of energy loss and collection of hot charge carriers, first step towards a more realistic hot-carrier solar energy converter, Solar Energy Materials and Solar Cells, 2006.09.06, Vol.90, No.14, pp.2107-2128 | 1<br>2-8 |
| X<br>A | Peter Wurfel et al., Particle Conservation in the Hot-carrier Solar Cell, Progress in Photovoltaics, 2005.06, Vol.13, No.4, pp.277-285 | 1<br>2-8 |

☐ Further documents are listed in the continuation of Box C.      ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>01 October, 2008 (01.10.08) | Date of mailing of the international search report<br>14 October, 2008 (14.10.08) |
|---|---|
| Name and mailing address of the ISA/<br>Japanese Patent Office | Authorized officer |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Robert T. Ross et al.** Efficiency of Hot-carrier Solar Energy Converters. *American Institute of Physics, Journal of Applied Physics,* May 1982, vol. 53 (5), 3813-3818
- Solar Energy Conversion with Hot Electrons from Impact Ionization. **Peter Würfel.** Solar Energy Materials and Solar Cells. Elsevier, 1997, vol. 46, 43-52
- **G. J. Conibeer et al.** On Achievable Efficiencies of Manufactured Hot Carrier Solar Cell Absorbers. *21st European Photovoltaic Solar Energy Conference,* 04 September 2006, 234-237
- Particle Conservation in the Hot-carrier Solar Cell. **Peter Würfel.** Progress in Photovoltaics: Research and Applications. Wiley InterScience, 18 February 2005, vol. 13, 277-285